# EUROPEAN PATENT APPLICATION

(11) **EP 3 540 765 A1**
(43) Date of publication of application: **18.09.2019**
(21) Application number: 16921421.0
(22) Date of filing: 11.11.2016
(51) Int. Cl.: H01L 21/56, B29C 33/18

(54) **RESIN-SEALING DEVICE AND RESIN-SEALING METHOD**

(71) Applicant: SHIN-ETSU ENGINEERING Co., Ltd., Tokyo 101-0054 (JP)
(72) Inventor: OHTANI Yoshikazu, Annaka-shi Gunma 379-0127 (JP); MORI Hiroharu, Tokyo 101-0054 (JP); TAKAHASHI Hiroshi, Tokyo 101-0054 (JP)
(74) Representative: Tomkinson, Alexandra
(86) International application number: PCT/JP2016/083590
(87) International publication number: WO 2018/087894

(57) **Abstract**

To perform resin sealing while securely adhesively holding a workpiece in a high vacuum state of approximately 100 Pa or lower. Provided is a resin-sealing device having: a first molding die that has a holding surface for a workpiece on which a semiconductor element is mounted; a second molding die that opposes a mounting surface of the workpiece on which the semiconductor element is mounted, and has a cavity to which an uncured resin is fed, the workpiece being held on the holding surface of the first molding die; a decompression chamber that is formed between the first molding die and the second molding die and configured to be openable and closeable; a driving part that forms the decompression chamber by bringing one or both of the first molding die and the second molding die close to the other or to each other relatively in an opposing direction of the first molding die and the second molding die; a pressure regulating part that exhausts air from the decompression chamber and an outer space or supply air thereto to regulate an internal pressure from an air atmosphere to a decompression atmosphere of a predetermined degree of vacuum; and a controlling part that controls operations of the driving part and the pressure regulating part, wherein the holding surface of the first molding die has an adhesive part that detachably comes into contact with a non-mounting surface provided on a side opposite to the mounting surface of the workpiece, and the controlling part controls to cause the driving part to immerse the mounting surface of the workpiece in the uncured resin in the cavity in a state where the decompression chamber is brought to a high vacuum of approximately 100 Pa or lower by the pressure regulating part.

## Description

### [Technical Field]

The present invention relates to a resin-sealing device used in the manufacture of a package such as a semiconductor package, and a resin-sealing method for manufacturing the package.

### [Background Art]

As this type of resin-sealing device, there has conventionally been known a resin-sealing device that has a substrate mounting part on which a substrate is mounted, an upper die having an air flow passage for suctioning the substrate, a cavity, the air flow passage communicating with the cavity, and a lower die having a heater (see PTL 1, for example).

A chip is placed on a primary surface of the substrate, and electrodes of the substrate and the chip are connected to each other by a wire.

The substrate mounting part of the upper die is provided, wherein a bottom surface of the substrate mounting part is provided with a suction recessed part and a decompression pump is connected to the suction recessed part via the air flow passage. The substrate is suctioned to the substrate mounting part by the air flow passage. Specifically, the pressure of the suction recessed part is reduced to negative pressure by suctioning from the air flow passage resulting from the operation of the decompression pump, and this substrate is suctioned by using the pressure difference between the suction recessed part and the space between the upper die and the lower die, holding the substrate in the substrate mounting part of the upper die in such a manner that the substrate cannot fall.

The resin material disposed in the cavity is heated and melted by the heater to produce a molten resin, and the upper die and the lower die are clamped while decompressing the space between the upper die and the lower die by means of the air flow passage. Consequently, the chip and the wire are immersed in the molten resin, which is then thermally cured, forming a molded article.

### [Citation List]

### [Patent Literature]

[PTL 1] Japanese Patent Application Laid-open No. 2004-174801

### [Summary of Invention]

### [Technical Problem]

Incidentally, when a resin material generally used for resin sealing (thermosetting resin such as an epoxy-based resin) is heated and melted in a decompression atmosphere, volatile components that are present in the resin evaporate and foam. Therefore, the resultant gas remains in the resin seal in the form of air bubbles, causing voids.

Unfortunately, in such a conventional resin-sealing device, a pressure difference of approximately several thousand Pa needs to be secured between the space between the upper die and the lower die and the suction recessed part in order to maintain the suctioning of the substrate onto the substrate mounting part of the upper die; the space between the upper die and the lower die cannot be decompressed to a high vacuum of approximately 100 Pa or lower.

For this reason, the gas generated as a result of heating and melting the resin material cannot reliably be exhausted air from the space between the upper die and the lower die and remains in the resin seal in the form of air bubbles, causing voids and lowering the quality.

Moreover, simply immersing the chip and the wire in the molten resin causes an air layer to remain in the gap between the substrate and the chip excluding the wire. This air layer serves as a void to interfere with the entry of the molten resin, preventing the molten resin from spreading across the entire gap. Such a molded article, unfilled with resin, has a problem that the chip is easily removed from the substrate, resulting in unstable electrical characteristics.

Therefore, for the purpose of solving such a problem, in a case where the space between the upper die and the lower die is decompressed to almost a high vacuum of approximately 100 Pa or lower without considering the secure suctioning and holding of the substrate, not only does the substrate often fall off in the middle of the decompression and the substrate is sealed while voids are contained therein, but also, by falling onto the molten resin, the substrate sometimes becomes displaced from the original suctioning and holding position in respect of the substrate mounting part of the upper die. Such displacement causes a part of the substrate to be exposed without being sealed with resin, resulting in a tendency to produce defective products and in lowering of the yield.

In addition, the suction recessed part provided in a recessed manner in the substrate mounting part of the upper die extends wide to suction most of the substrate. Therefore, when press molding is performed placing several tens of tons of pressure to clamp the upper die and the lower die, the pressure concentrates on the part of the substrate that corresponds to the relatively large suction recessed part, causing the substrate to locally fracture.

### [Solution to Problem]

In order to solve such problems, a resin-sealing device according to the present invention has: a first molding die that has a holding surface for a workpiece on which a semiconductor element is mounted; a second molding die that opposes a mounting surface of the workpiece on which the semiconductor element is mounted, and has a cavity to which an uncured resin is fed, the workpiece being held on the holding surface of the first molding die; a decompression chamber that is formed between the first molding die and the second molding die and configured to be openable and closeable; a driving part that forms the decompression chamber by bringing one or both of the first molding die and the second molding die close to the other or to each other relatively in an opposing direction of the first molding die and the second molding die; a pressure regulating part that exhausts air from the decompression chamber and an outer space or supplies air thereto to regulate an internal pressure from an air atmosphere to a decompression atmosphere of a predetermined degree of vacuum; and a controlling part that controls operations of the driving part and the pressure regulating part,
wherein the holding surface of the first molding die has an adhesive part that detachably comes into contact with a non-mounting surface provided on a side opposite to the mounting surface of the workpiece, and the controlling part controls to cause the driving part to immerse the mounting surface of the workpiece in the uncured resin in the cavity in a state where the decompression chamber is brought to a high vacuum of approximately 100 Pa or lower by the pressure regulating part.

Also, a resin-sealing method according to the present invention has: a carrying-in step for, under an air atmosphere, causing an adhesive part, which is provided on a holding surface of the first molding die, to adhesively hold a workpiece on which a semiconductor element is mounted, against the holding surface of the first molding die that is moved away relatively in an opposing direction of the first molding die and the second molding die, and supplying an uncured resin to a cavity of the second molding die; a decompression step for causing the driving part to bring one or both of the first molding die and the second molding die close to the other or to each other relatively in the opposing direction of the first molding die and the second molding die, thereby forming a decompression chamber between the first molding die and the second molding die, and causing a pressure regulating part to exhaust air from the decompression chamber to an outer space, to decompress from the air atmosphere; an immersing step for causing the driving part to immerse the mounting surface of the workpiece and the semiconductor element in the uncured resin in the cavity in a state where the decompression chamber reaches a high vacuum of approximately 100 Pa or lower; a curing step for curing the uncured resin to resin-seal the mounting surface of the workpiece and the semiconductor element; and a carrying-out step for causing the pressure regulating part to bring the decompression chamber back to the air atmosphere by supplying air thereto from the outer space, peeling a non-mounting surface, provided on a side opposite to the mounting surface of the workpiece, from the adhesive part on the mounting surface of the workpiece, and causing the driving part to move the first molding die and the second molding die away from each other.

### [Brief Descriptions of Drawings]

Fig. 1 is an explanatory drawing showing the entire configuration of a resin-sealing device according to an embodiment of the present invention, the explanatory drawing being a longitudinal sectional front view of the initial state (carrying-in step).
Fig. 2(a) and Fig. 2(b) is a plan view and a cross-sectional view of the resin-sealing device, where Fig 2(a) is a reduced cross-sectional plan view in which an uncured resin and a release sheet are omitted, and Fig 2(b) is a longitudinal sectional view taken along line (2B) - (2B) of Fig. 2(a), Fig. 1 being a longitudinal sectional view taken along line (1) - (1) of Fig. 2(a).
Fig. 3(a) and Fig. 3(b) is an explanatory drawing showing an operation process of a resin-sealing method according to an embodiment of the present invention, where Fig 3(a) is a longitudinal sectional front view of a decompression step, and Fig 3(b) is a longitudinal sectional front view of an immersing step.
Fig. 4(a) and Fig. 4(b) shows a subsequent operation process, where Fig 4(a) is a longitudinal sectional front view of a compression step, and Fig 4(b) is a longitudinal sectional front view of a compressed state obtained using a plunger and a curing step.
Fig. 5(a) and Fig. 5(b) shows a subsequent operation step, where Fig 5(a) is a longitudinal sectional front view of a carrying-out step, and Fig 5(b) is a longitudinal sectional front view of a state where a molded article is retrieved.
Fig. 6 is an explanatory drawing showing a modification of a device according to an embodiment of the present invention, the explanatory drawing being a longitudinal sectional front view of the initial state (preparation step).
Fig. 7 is an explanatory drawing showing a modification of the resin-sealing device according to the embodiment of the present invention, the explanatory drawing being a longitudinal sectional front view of the initial state (preparation step).

### [Description of Embodiments]

Embodiments of the present invention are described hereinafter in detail with reference to the drawings.

A resin-sealing device A according to an embodiment of the present invention is a manufacturing apparatus for "mold formation (resin sealing, resin molding)", which, in a semiconductor assembly process, mounts a plurality of semiconductor elements C on a workpiece W, connects substrate terminals of the workpiece W to the semiconductor elements C using connecting members C1 such as wires, and then seals the surroundings of the connecting sections C1 with an uncured resin R and cures the resin in order to protect the resultant product from impact, temperature, humidity, and the like.

Examples of the workpiece W include a substrate composed of a silicon wafer, a glass, a metal sheet, a glass cloth, a BT resin, or the like, as well as objects similar to such substrate.

Examples of the semiconductor elements C include chip-like electronic components such as semiconductor chips, and when mounting the plurality of semiconductor elements C on a mounting surface W1 of the workpiece W which is a substrate composed of a silicon wafer, a glass or the like, the plurality of semiconductor elements C are mounted in a row or grid. Examples of the connecting sections C1 include bumps, wires, and the like.

As the uncured resin R, the one in the form of sheet, powder, granule, gel or the like is used. Examples of a material of the uncured resin R include a thermosetting resin such as an epoxy-based resin. Epoxy-based resin is suitable for mold formation because the epoxy-based resin thermally decomposes within a predetermined period of time since heating thereof begins, increases its viscosity with the lapse of time from the molten state, and gelates and solidifies within a relatively short period of time.

A molded article M that is produced by the resin-sealing device A in such a manner described above is generally subjected to a dividing step such as dicing, to complete a package such as a semiconductor package, which is the final product.

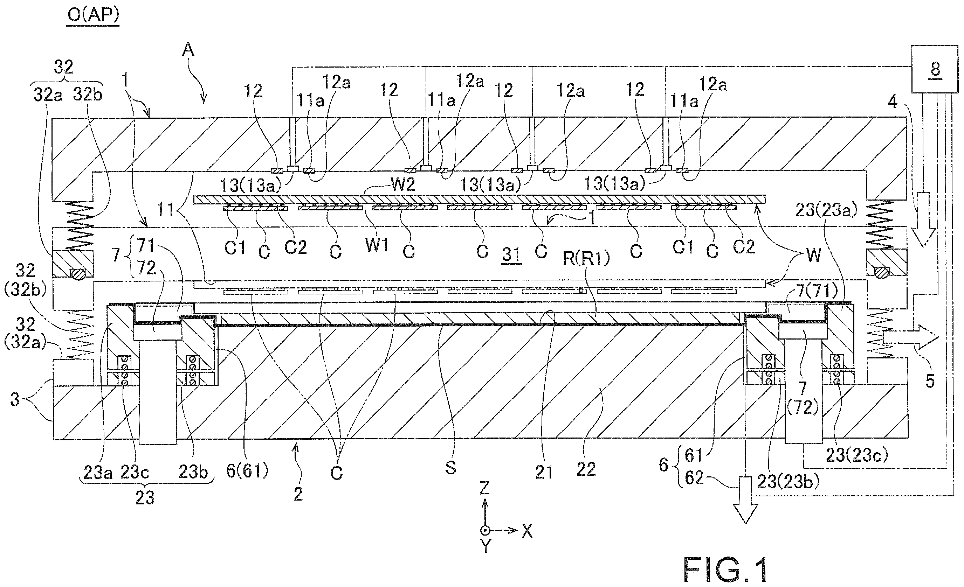

More specifically, as shown in Figs. 1 to Fig. 7, the resin-sealing device A according to the embodiment of the present invention has, as the primary components thereof: a first molding die 1 that has a holding surface 11 for holding the workpiece W; a second molding die 2 that opposes a mounting surface W1 of the workpiece W held on the holding surface 11 of the first molding die 1 and has a cavity 21; a decompression chamber 31 that is formed in an openable/closeable manner between the first molding die 1 and the second molding die 2; a driving part 4 for lifting and lowing that forms the decompression chamber 31 by bringing one or both of the first molding die 1 and the second molding die 2 close to the other or to each other relatively in an opposing direction of the first molding die 1 and the second molding die 2; a pressure regulating part 5 that exhausts air from the decompression chamber 31 and an outer space O or supplies air thereto to regulate an internal pressure.

Furthermore, if necessary, it is preferred that a release sheet S be used at least between the uncured resin R and the cavity 21, and it is preferred that compression molding be performed by compressing the uncured resin R in the cavity 21.

Therefore, it is preferred that the resin-sealing device A according to the embodiment of the present invention have a positioning part 6 that determines the position of the release sheet S with respect to the cavity 21, and compression part 7 that compresses the uncured resin R.

The driving part 4, the pressure regulating part 5, the positioning part 6, the compression part 7 and the like electrically communicate with a controlling part 8, and the controlling part 8 controls the operations of these components.

Note that the first molding die 1 and the second molding die 2 are usually disposed in such a manner as to oppose each other in a vertical direction, as shown in Figs. 1 to 7, and the direction in which the first molding die 1 on the upper side and the second molding die 2 on the lower side come close to each other or separate from each other is hereinafter referred to as "Z direction." The direction along the workpiece W that intersects with the Z direction is hereinafter referred to as "XY direction."

The first molding die 1 is a rigid body such as metal and is formed in the shape of a flat plate having a thickness that does not cause distortion (sagging) thereof, and a surface of the first molding die 1 has a holding surface 11 that opposes, in the Z direction, a non-mounting surface W2 of the workpiece W that is located on the side opposite to the mounting surface W1.

According to a specific example of the first molding die 1, in the examples shown in Figs. 1 to 7, the first molding die 1 is an upper die that is disposed on the substrate side to be molded. The smooth holding surface 11 is formed in a central part or in whole of an inner surface of this upper die in such a manner as to come into contact with the non-mounting surface W2 of the workpiece W.

The holding surface 11 of the first molding die 1 is provided with adhesive parts 12 as holding chucks that detachably come into contact with the non-mounting surface W2 of the workpiece W.

In the examples shown in Figs. 1 to 7, a disc-shaped silicon wafer is used as the workpiece W, and the silicon wafer is held in a suspended manner against the holding surface 11 of the first molding die 1 by the adhesive parts 12 provided as holding chucks.

Also, according to another example which is not shown, in place of the silicon wafer used as the workpiece W, a substrate composed of a glass, a metal sheet, a glass cloth, a BT resin, or the like, or an object similar to such substrate, can be held (in a suspended manner), or the outer shape of the workpiece W can be changed into a rectangle (a quadrangle with right angles, including rectangles and squares).

The whole or part of each adhesive part 12 is made of, for example, fluororubber, elastomer, butyl rubber, photosensitive resin, or an acrylic-based or silicon-based adhesive material. It is preferred that the adhesive parts 12 have adhesive surfaces 12a that are elastically deformable and protrude from the holding surface 11 of the first molding die 1 toward the decompression chamber 31 which is described hereinafter.

According to this configuration, the workpiece W cannot drop even when the decompression chamber 31 reaches a decompression atmosphere DP of a predetermined degree of vacuum.

It is preferred that the shape of the adhesive part 12 be in the form of a sheet.

It is preferred that the size of each adhesive part 12 be much smaller than the mounting surface W1 of the workpiece W and that a plurality of the adhesive parts 12 be arranged dispersedly in the holding surface 11 of the first molding die 1.

According to a specific example of the adhesive parts 12, in the examples shown in Figs. 1 to 7, a plurality of recessed groove parts 11a are dispersedly formed on the holding surface 11 of the first molding die 1, and the diameter of each recessed groove part 11a is set at approximately 10 mm or less. Adhesive sheets constituting the adhesive parts 12 are fitted into the respective recessed groove parts 11a, where the adhesive surfaces 12a protrude slightly (approximately 50 µm or less) from the holding surface 11 of the first molding die 1.

In another example, which is not shown, in addition to the adhesive parts 12, suction chucks or electrostatic chucks can be used together as the holding chucks for the workpiece W.

It is also preferred that the holding surface 11 of the first molding die 1 has pushing part 13 that moves the non-mounting surface W2 of the workpiece W toward the adhesive surfaces 12a of the adhesive parts 12 and presses the non-mounting surface W2 against the adhesive surfaces 12a, and peeling part 14 that peels the non-mounting surface W2 of the workpiece W from the adhesive surfaces 12a of the adhesive parts 12.

The force of the pushing part 13 pressing the workpiece W is set in such a manner that the non-mounting surface W2 of the workpiece W crushes the adhesive surfaces 12a of the adhesive parts 12 that protrude slightly from the holding surface 11 of the first molding die 1 and that the holding surface 11 of the first molding die 1 and the non-mounting surface W of the workpiece W are in close contact with each other so as not to form a gap that allows the entry of the uncured resin R.

According to a specific example of the pushing part 13, in the examples shown in Figs. 1 to 7, a plurality of suction holes 13a are opened and dispersedly arranged in the holding surface 11 of the first molding die 1, the size of each suction hole 13a being set to be substantially equal to that of each recessed groove part 11a. Each of the suction holes 13a communicates with an actuator such as a compressor (not shown) for vacuum suction and gas injection. Vacuum suction from the suction holes 13a by the operation of the actuator draws the non-mounting surface W2 of the workpiece W toward the adhesive parts 12 and pushes the non-mounting surface W2 against the adhesive surfaces 12a.

It is preferred that push pin 14a be used as the peeling part 14, the push pin 14a being provided so as to be able to reciprocate in the Z direction with respect to the first molding die 1, and that the non-mounting surface W2 of the workpiece W be peeled from the adhesive surfaces 12a using tip end of the push pin 14a. According to another example of the peeling part 14, the non-mounting surface W2 of the workpiece W can be peeled from the adhesive surfaces 12a by injecting compressed gas from the suction holes 13a.

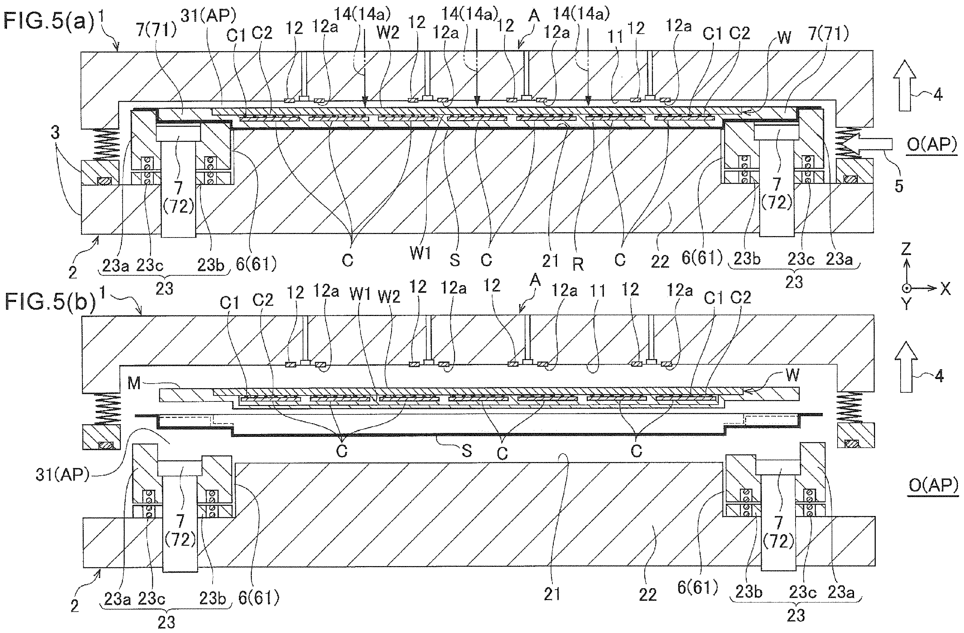

In the examples shown in Figs. 1 to 7, the plurality of adhesive parts 12 are dispersedly arranged around the suction holes 13a respectively. In the example shown in Fig. 5(a), the workpiece W is peeled only by using the push pin 14a as the peeling part 14.

According to another example which is not shown, changes can be made such as electrostatic chucks can be used as the pushing part 13 for pushing the workpiece W in place of the suction holes 13a, wherein the non-mounting surface W2 of the workpiece W is drawn toward and pressed against the adhesive parts 12 by the electromagnetic attraction of the electrostatic chucks, or the non-mounting surface W2 of the workpiece W can be peeled from the adhesive surfaces 12a by electrical repulsive force. A combination of the push pin 14a and injection of compressed gas from the suction holes 13a can be used as the peeling part 14.

The second molding die 2 is a rigid body such as metal and is formed in the shape of a flat plate having a thickness that does not cause distortion (sagging),thereof, and a surface of the second molding die 2 that opposes, in the Z direction, the mounting surface W1 of the workpiece W on which the semiconductor elements C are mounted, is provided with a cavity 21 to which the uncured resin R is fed. The cavity 21 is formed into a concave shape that has a size (volume) for accommodating at least the mounting surface W1 of the workpiece W and all of the connecting members C1 of the semiconductor elements C.

Furthermore, at least the second molding die 2 is provided with a heater (not shown) for heating the cavity 21 and the surrounding thereof. Note that the heater can be provided in the first molding die 1 as well.

According to a specific example of the second molding die 2, in the examples shown in Figs. 1 to 7, the second molding die 2 is a lower die that is disposed on the resin side to be molded. In a central part of an inner surface of this lower die, the circular cavity 21 in which the uncured resin R and all of the semiconductor elements C and connecting members C1 can be accommodated, and a circular recessed part for accommodating the entire workpiece W, are formed integrally in a continuous manner.

Also, according to another example which is not shown, changes can be made such as the shape of the cavity 21 can be changed to a rectangular shape in order to match the outer shape of the workpiece W, or only the cavity 21 can be formed without forming the recessed part for accommodating the entire workpiece W.

According to a specific example of the uncured resin R, in the examples shown in Figs. 1 to 5, a sheet-like thermosetting resin R1 is fed to the cavity 21 and heated and melted by the heater.

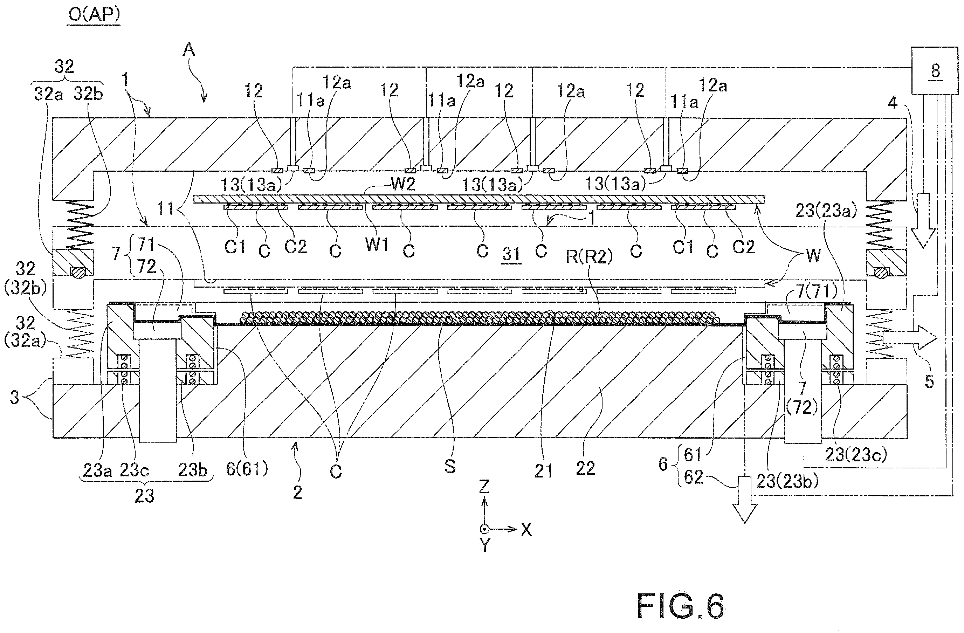

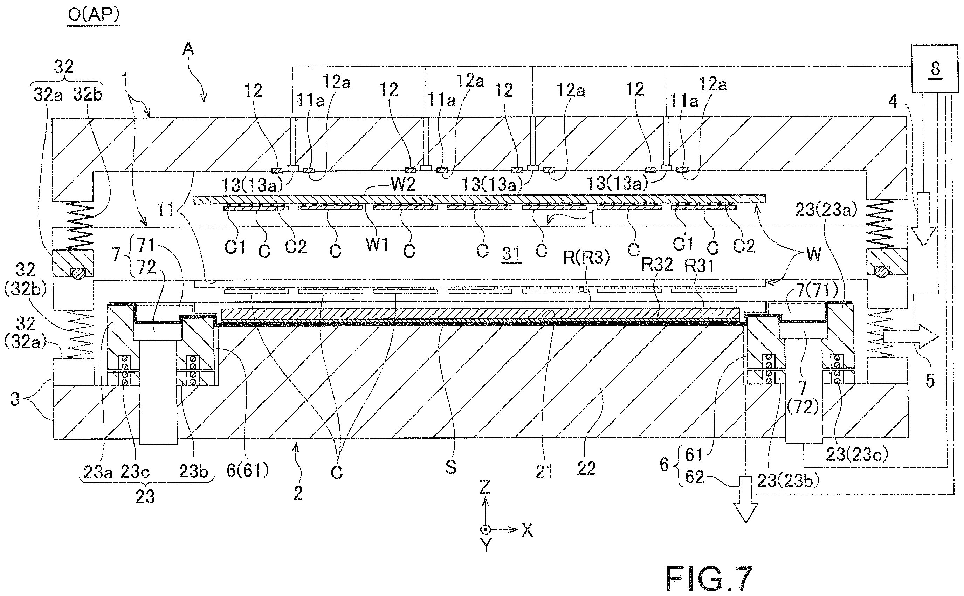

According to another example of the uncured resin R, changes can be made such as a thermosetting resin R2 in the form of powder or granule can be fed to the cavity 21 and heated and melted by the heater as shown in Fig. 6, or the cavity 21 can be fed with a fiber-containing resin substrate R3 obtained by immersing an uncured resin layer R31 in a resin-impregnated fiber base material R32 as shown in Fig. 7, or an uncured resin in the form of gel, not shown, can be fed to the cavity 21.

As shown in Fig. 6, the powdered or granular thermosetting resin R2 has the advantage of being excellent in workability because fine adjustment can be made to the volume of the uncured resin R more easily compared to the sheet-like thermosetting resin R1 or the fiber-containing resin substrate R3.

As described in Japanese Patent Application No. 5934078, the fiber-containing resin substrate R3 shown in Fig. 7 has the resin-impregnated fiber base material R32 composed of carbon fiber, glass fiber, quartz glass fiber or the like having a linear expansion coefficient of less than 3 ppm in the XY direction, and the uncured resin layer R31 formed on one side of the resin-impregnated fiber base material R32 and composed of uncured epoxy-based resin or the like.

The modification shown in Fig. 7 has the advantage that, because the shrinkage stress obtained as a result of curing the uncured resin layer R31 can be suppressed, in a case where a large-diameter substrate such as a large-diameter wafer or a large-diameter metal is sealed as the workpiece W, especially even when sealing a thin substrate, not only is it possible to prevent warpage of the workpiece W (wafer or substrate), peeling of the semiconductor elements C from the workpiece W (wafer or substrate), and breakage of the workpiece W (wafer or substrate), but also the mounting surface W1 of the workpiece W (wafer or substrate) on which the semiconductor elements C are mounted or the mounting surface W1 of the workpiece W (wafer or substrate) on which the semiconductor elements C are formed can be sealed integrally as the whole workpiece W (wafer or substrate), providing excellent sealing performance such as heat resistance and moisture resistance after sealing.

It is also preferred that the second molding die 2 be divided into a central section 22 constituting a bottom surface part of the cavity 21 and an outer section 23 constituting a side surface part of the cavity 21, and that a suction slit 61 be formed between the central section 22 and the outer section 23 as the positioning part 6 for determining the position of the release sheet S.

The suction slit 61 communicates with a suction device 62 such as a vacuum pump, and determines the position of the release sheet S of excellent elasticity and holds the release sheet S in such a manner that the release sheet S becomes bent and deformed along the shapes of the bottom surface part and side surface part of the cavity 21.

Also, according to another example which is not shown, the second molding die 2 can be formed integrally without dividing the second molding die 2 into the central section 22 and the outer section 23.

The outer section 23 has a driven part 23a that comes into contact with the first molding die 1 regardless of the presence of the release sheet S, a stopper 23b that regulates the movement of the first molding die 1 and the driven part 23 in the Z direction, and an elastic member 23c that constantly biases the driven part 23a toward the first molding die 1.

The driven part 23a is supported so as to be able to reciprocate in the Z direction, and the distance from the holding surface 11 of the first molding die 1 to the bottom surface part of the cavity 21 is set to be equal to the thickness of the molded article M including the workpiece W, in a state that the first molding die 1 being in abutment via the stopper 23b with the driven part 23 therebetween.

Additionally, it is preferred that the outer section 23 be provide with the compression part 7 for compressing the uncured resin R.

The compression part 7 for compressing the uncured resin R has an overflow passage 71 formed in a continuous manner on the outside of the cavity 21, and a plunger 72 that is provided in such a manner as to protrude toward the overflow passage 71.

The plungers 72 are supported so as to be able to reciprocate in the Z direction with respect to the driven part 23a and the like in order to reduce the volumes of the overflow passage 71, and are configured to compress the uncured resin R that pours out of the cavity 21 into the overflow passage 71 as a result of immersing the semiconductor elements C in the uncured resin R in the cavity 21.

According to a specific example of the compression part 7, in the examples shown in Figs. 1 to 7, a plurality of the overflow passages 71 are formed radially in the XY direction, with the cavity 21 at the center, and the plungers 72 are disposed at bottom surface tip ends of the respective overflow passages 71.

According to another example which is not shown, the shapes and structures of the outer section 23 and the compression part 7 can be changed to shapes and structures that are not shown.

The decompression chamber 31 is formed inside of a vacuum device 3 composed of a vacuum chamber or the like, and air is exhausted (vacuum evacuation, vacuum drawing) from the decompression chamber 31 by the operation of an exhaust device 5 such as a vacuum pump. Therefore, the decompression chamber 31 is configured to be able to adjust a pressure change from an air atmosphere AP to the decompression atmosphere DP of a predetermined degree of vacuum.

The vacuum device 3 is entirely or partially configured to be openable and closeable so as to allow the workpiece W, the uncured resin R, the release sheet S, the molded article M and the like to be taken in and out of the decompression chamber 31. Automation can be achieved by providing a carrying mechanism (not shown), such as a carrying robot, across the decompression chamber 31 in the vacuum device 3 and the outer space 0 of the vacuum device 3.

More specifically, when the decompression chamber 31 is under the air atmosphere AP, the carrying mechanism carries the workpiece W, the uncured resin R, and the release sheet S into the decompression chamber 31. Mold formation is executed once the decompression chamber 31 is under the decompression atmosphere DP of a predetermined degree of vacuum. After the completion of the mold formation, the decompression chamber 31 is brought back to the air atmosphere AP and the molded article M is carried from the decompression chamber 31 out to the outer space O.

According to a specific example of the vacuum device 3, in the examples shown in Figs. 1 to 7, a peripheral wall part 32 is provided in an outer circumference of the first molding die 1 constituting the upper side of the vacuum device 3, in such a manner as to detachably come into close contact with an outer circumferential part of the second molding die 2 constituting the lower side of the vacuum device 3. The peripheral wall part 32 has a seal section 32a that comes into close contact with the outer circumferential part of the second molding die 2 in the Z direction, and an expandable section 32b that is elastically deformable in the Z direction.

According to another example which is not shown, changes can be made such as, instead of providing the peripheral wall part 32 in the first molding die 1, a peripheral wall part can be provided in an outer circumference of the second molding die 2, or peripheral wall parts capable of separating in the Z direction can be provided in the outer circumferences of the first molding die 1 and the second molding die 2.

The driving part 4 for lifting and lowering is configured by an actuator or the like, for reciprocating one or both of the first molding die 1 and the second molding die 2 in the Z direction, wherein the actuation of the driving part 4 is controlled by the controlling part 8 described hereinafter.

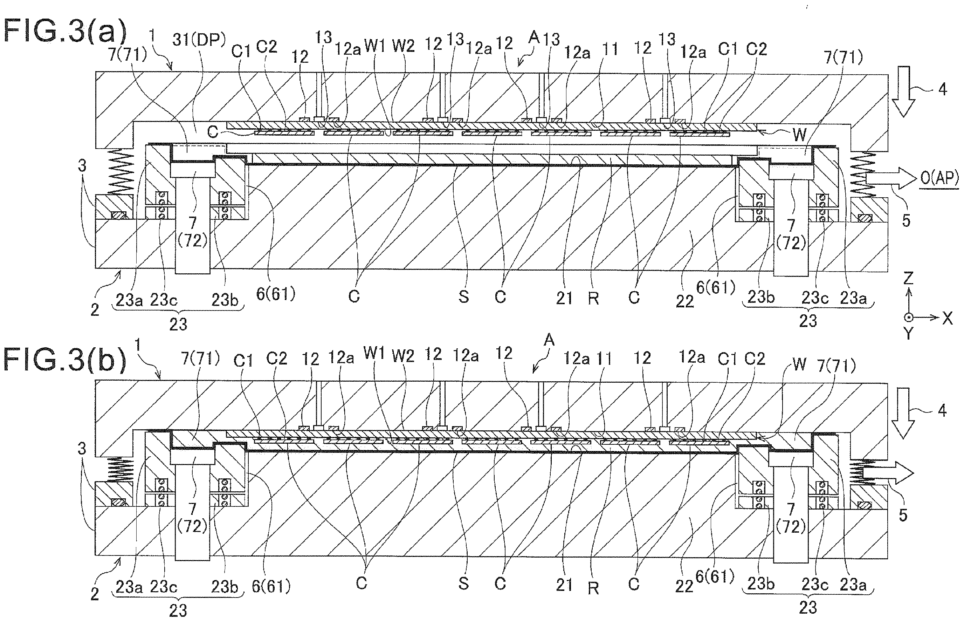

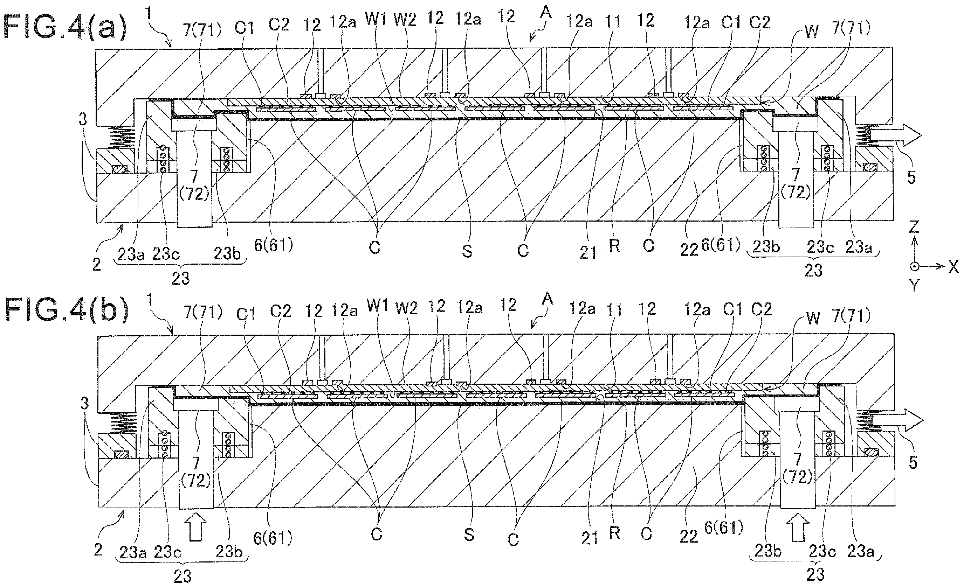

According to an example of controlling the driving part 4 by means of the controlling part 8, when carrying the workpiece W, the uncured resin R, and the release sheet S into the decompression chamber 31 as shown by the solid line in Fig. 1 and when carrying the molded article M out of the decompression chamber 31 as shown in Figs. 5(a) and 5(b), the driving part 4 for lifting and lowering is caused to separate either the first molding die 1 or the second molding die 2 away from the other relatively in the Z direction or to separate both the first molding die 1 and the second molding die 2 from each other relatively in the Z direction. In other cases, as shown in Figs. 3(a), 3(b), 4(a), and 4(b), the driving part 4 for lifting and lowering brings either the first molding die 1 or the second molding die 2 close to the other relatively in the Z direction or brings both the first molding die 1 and the second molding die 2 close to each other relatively in the Z direction. If especially necessary, the first molding die 1 and the second molding die 2 are brought close to each other and compressed.

According to a specific example of the driving part 4 for lifting and lowering, in the example shown in Fig. 1, only the first molding die 1 is linked to the driving part 4 for lifting and lowering, and the first molding die 1 is brought close to the second molding die 2 in the Z direction.

Furthermore, according to another example which is not shown, changes can be made such as only the second molding die 2 is linked to the driving part 4 for lifting and lowering, and the second molding die 2 is brought close to the first molding die 1 relatively in the Z direction, or the first molding die 1 and the second molding die 2 are linked to the driving part 4 for lifting and lowering, to simultaneously bring both the first molding die 1 and the second molding die 2 close to each other in the Z direction.

The controlling part 8 is a controller that is electrically connected not only to the driving part 4 for lifting and lowering and the pressure regulating part 5, but also to the actuator for the suction holes 13a, the suction device 62 of the positioning part 6 for positioning the release sheet S, the plungers 72 of the compression part 7 for compressing the uncured resin R, the carrying mechanism for carrying the workpiece W, the uncured resin R, and the release sheet S, and the like.

The controller functioning as the controlling part 8 controls the actuation of each component sequentially at preset timings in accordance with a program set beforehand in a control circuit (not shown) of the controlling part 8.

Next is described the program that is set in the control circuit of the controlling part 8 as the resin-sealing method for producing the molded article M.

The resin-sealing method according to an embodiment of the present invention includes, as the primary steps, a carrying-in step for carrying and setting the workpiece W, the uncured resin R, and the release sheet S in the decompression chamber 31 that is opened, a decompression step for decompressing the decompression chamber 31 formed between the first molding die 1 and the second molding die 2, an immersing step for immersing the mounting surface W1 of the workpiece W in the uncured resin R in the cavity 21 in a high vacuum state of approximately 100 Pa or lower, a curing step for curing the uncured resin R to resin-seal the mounting surface W1 of the workpiece W and the semiconductor elements C, and a carrying-out step for releasing the decompression chamber 31 to the atmosphere and opening the decompression chamber 31 to retrieve the molded article M.

In particular, it is preferred that between the immersing step and the curing step be provided a compression step for causing the driving part 4 for lifting and lowering to bring one or both of the first molding die 1 and the second molding die 2 close to the other or to each other in the opposing direction (Z direction) of the first molding die 1 and the second molding die 2.

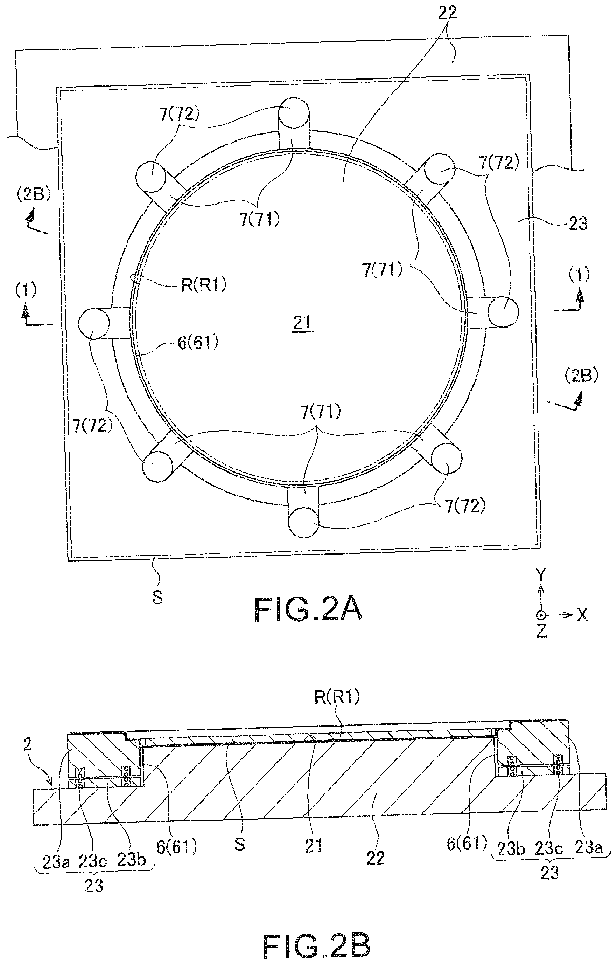

As shown in Figs. 1 and Fig. 2 or in Fig. 6 or Fig. 7, under the air atmosphere AP, the carrying-in step causes the carrying mechanism to carry the workpiece W to the holding surface 11 of the first molding die 1 that is moved away relatively along the Z direction, causes the adhesive parts 12 to adhesively hold the workpiece W, and causes the carrying mechanism to sequentially feed the release sheet S and the uncured resin R to the cavity 21 of the second molding die 2 and set the release sheet S and the uncured resin R in the respective predetermined positions thereof.

As shown in Fig. 3(a), the decompression step causes the driving part 4 for lifting and lowering to bring one or both of the first molding die 1 and the second molding die 2 close to the other or to each other relatively in the Z direction, forms the decompression chamber 31 across the gap between the first molding die 1 and the second molding die 2, and causes the pressure regulating part 5 to decompress the decompression chamber 31 from the air atmosphere AP by exhausting air from the decompression chamber 31 to the outer space O.

As shown in Fig. 3(b), the immersing step causes the driving part 4 to immerse the mounting surface W1 of the workpiece W and the semiconductor elements C in the uncured resin R of the cavity 21 in a state where the decompression chamber 31 reaches a high vacuum of approximately 100 Pa or lower.

In so doing, the uncured resin R is heated and melted by the heater.
Therefore, once the mounting surface W1 of the workpiece W and the semiconductor elements C are immersed, the molten uncured resin R pours into the overflow passage 71.

In the compression step, as shown in Fig. 4(a), the driven part 23a of the outer section 23 that is in contact with the first molding die 1 approaches the stopper 23b in the Z direction to come into abutment therewith, and the first molding die 1 and the second molding die 2 are clamped, compressing the uncured resin R.
Subsequently, as shown in Fig. 4(b), the plungers 72 protrude toward the overflow passage 71, further compressing the uncured resin R pouring out of the cavity 21 into the overflow passage 71.

In the subsequent curing step, the uncured resin R in the cavity 21 and overflow passage 71 is cured, whereby the mounting surface W1 of the workpiece W, the semiconductor elements C, and gaps C2 between the mounting surface W1 and the semiconductor elements C, excluding the connecting members C1, are integrally resin-sealed.

After the uncured resin R is cured, the plungers 72 move backward as shown in Fig. 5(a), proceeding to the carrying-out step.

The carrying-out step causes the pressure regulating part 5 to supply air from the outer space 0 to the decompression chamber 31 to bring back to the air atmosphere AP, causes the peeling part 14 to peel the non-mounting surface W2 of the workpiece W from the adhesive parts 12 on the holding surface 11 of the first molding die 1, and thereafter causes the driving part 4 for lifting and lowering to separate the first molding die 1 and the second molding die 2 from each other.

Subsequently, once the first molding die 1 and the second molding die 2 are separated from each other to open the vacuum device 3 as shown in Fig. 5(b), the molded article M obtained after the completion of resin sealing and the release sheet S are carried from the decompression chamber 31 to the outer space O by the carrying mechanism. The molded article M and the release sheet S are separated in the decompression chamber 31 or the outer space 0.

According to the resin-sealing device A and the resin-sealing method of the embodiments of the present invention, even when the decompression chamber 31 is decompressed by the pressure regulating part 5 to a high vacuum of approximately 100 Pa or lower as the decompression atmosphere DP, the non-mounting surface W2 of the workpiece W is adhesively held on the holding surface 11 of the first molding die 1 by the adhesive parts 12.

By causing the driving part 4 to immerse the mounting surface W1 of the workpiece W in the uncured resin R of the cavity 21 in this high vacuum state, the uncured resin R can smoothly enter the entire gap C2 between the mounting surface W1 of the workpiece W and the semiconductor elements C, excluding the connecting members C1, and spread sufficiently even the gaps C2 are as narrow as approximately several tens µm.

As a result, compared to the prior art where a pressure difference of approximately several thousand Pa needs to be secured between the space between the upper die and the lower die and the suction recessed part in order to allow the substrate mounting part of the upper die to keep suctioning the substrate, the air can efficiently be exhausted to the outside of the decompression chamber 31 by the pressure regulating part 5 even when the uncured resin R foams in the decompression chamber 31, and at the same time air in the gaps C2 between the mounting surface W1 of the workpiece W and the semiconductor elements C can reliably be exhausted. Consequently, the gas does not remain in the resin seal in the form of air bubbles; thus, not only is it possible to prevent the generation of voids, but also a package that is sealed with resin with high accuracy can be realized, and quality improvement can be achieved.

In addition, regardless of the decompression chamber 31 is decompressed or not, the non-mounting surface W2 of the workpiece W is adhesively held on the holding surface 11 of the first molding die 1 by the adhesive parts 12 in such a manner that the workpiece W is not displaced, preventing positional displacement of the workpiece W with respect to the holding surface 11 of the first molding die 1. As a result, a package that is sealed with resin with higher accuracy can be realized, and improvement in stability and yield can be achieved.

In particular, it is preferred that the plurality of adhesive parts 12 be arranged dispersedly on the holding surface 11 of the first molding die 1.

In this case, the size of each adhesive part 12 and the size of each recessed groove part 11a for attaching the adhesive parts 12 thereto are much smaller than the size of the workpiece W. Thus, when press molding is performed placing several tens of tons of pressure onto the workpiece W to clamp the first molding die 1 and the second molding die 2, the large pressure cannot easily be applied convergently on the workpiece W.

In order to demonstrate this effect, the following experiments were conducted.
- Example: A projecting part with a diameter equal to or smaller than 10 mm and a recessed part with a diameter equal to or smaller than 10 mm were provided on the holding surface 11 of the first molding die 1.
- Comparative example: A projecting part with a diameter larger than 10 mm and a recessed part with a diameter larger than 10 mm were provided on the holding surface 11 of the first molding die 1.
- Experimental device: A pressure of several tens of tons is applied to a silicon wafer used as the workpiece W, by clamping the first molding die and the second molding die 2 of the example or the comparative example. Consequently, whether cracks were generated in the silicon wafer or not was investigated.
- Experimental result: in the example provided with the projecting part and the recessed part each having a diameter equal to or less than 10 mm, cracks were not generated in the silicon wafer.

On the other hand, in the comparative example provided with the projecting part and the recessed part each having a diameter larger than 10 mm, cracks were generated in the silicon wafer.

Therefore, the workpiece W can be prevented from being locally subjected to a large pressure when clamping the first molding die 1 and the second molding die 2.

As a result, compared to the prior art in which the suction recessed part provided in a recessed manner in the substrate mounting part of the upper die extends wide to suction most of the substrate, the present invention can prevent the generation of cracks in the workpiece W, further improving the yield.

Furthermore, it is preferred that the adhesive parts 12 have the adhesive surfaces 12a that are elastically deformable and protrude from the holding surface 11 of the first molding die 1 toward the decompression chamber 31.

In a case where the adhesive parts 12 are attached to the recessed groove parts 11a formed in the holding surface 11 of the first molding die 1 in such a manner that the amount of protrusion (protrusion allowance) of the adhesive surfaces 12a from the holding surface 11 is small (approximately 50 µm or less), the non-mounting surface W2 of the workpiece W that is carried into the decompression chamber 31 comes into contact with the adhesive surfaces 12a of the adhesive parts 12 prior to the holding surface 11 of the first molding die 1 and is adhesively held on the adhesive surfaces 12a. The adhesive surfaces 12a of the adhesive parts 12 are compressed and deformed as a result of clamping the first molding die 1 and the second molding die 2 and become flush with the holding surface 11 of the first molding die 1, bringing the non-mounting surface W2 of the workpiece W into close contact with the holding surface 11 of the first molding die 1.

As a result, the present invention can simultaneously achieve secure adhesive holding of the workpiece W to the holding surface 11 of the first molding die 1 at the time of carrying the workpiece W in, and prevention of the infiltration of the uncured resin R between the first molding die 1 (holding surface 11) and the workpiece W (non-mounting surface W2) at the time of clamping the first molding die 1 and the second molding die 2.

Consequently, while achieving stable adhesive holding of the workpiece W, the generation of cracks in the workpiece W due to the protrusion of the adhesive surfaces 12a can be prevented.

Moreover, not only is it possible to prevent the production of package defects caused by the infiltration of the uncured resin R between the workpiece W and the first molding die 1, but also the yield can be further improved, achieving excellent productivity.

Also, it is preferred that the holding surface 11 of the first molding die 1 have the pushing part 13 that moves the workpiece W toward the adhesive surfaces 12a of the adhesive parts 12 and presses the workpiece W against the adhesive surfaces 12a.

In this case, since the non-mounting surface W2 of the workpiece W is brought into contact with the adhesive surfaces 12a of the adhesive parts 12 by the pushing part 13 and is then further pressed against the adhesive surfaces 12a, the adhesive surfaces 12a are pressure-joined with the non-mounting surface W2 while being compressed and deformed.

Therefore, the workpiece W can reliably be prevented from falling off the adhesive surfaces 12a of the adhesive parts 12.

Consequently, the stability of adhesive holding of the workpiece W is improved, achieving excellent productivity.

Note that, as shown in the illustrated examples according to the foregoing embodiments, the first molding die 1 is the upper die disposed on the substrate side to be molded, and the second molding die 2 is the lower die disposed on the resin side to be molded, but the present invention is not limited to this configuration; the first molding die 1 may be the lower die disposed on the resin side to be molded, and the second molding die 2 may be the upper die disposed on the substrate side to be molded.

### [Reference Signs List]

- A: Resin-sealing device
- 1: First molding die
- 11: Holding surface
- 12: Adhesive part
- 12a: Adhesive surface
- 13: Pushing part
- 2: Second molding die
- 21: Cavity
- 31: Decompression chamber
- 4: Driving part
- 5: Pressure regulating part
- 8: Controlling part
- AP: Air atmosphere
- DP: Decompression atmosphere
- C: Semiconductor element
- 0: Outer space
- R: Uncured resin
- W: Workpiece
- W1: Mounting surface
- W2: Non-mounting surface

## Claims

1. A resin-sealing device, comprising:
a first molding die that has a holding surface for a workpiece on which a semiconductor element is mounted;
a second molding die that opposes a mounting surface of said workpiece on which said semiconductor element is mounted, and has a cavity to which an uncured resin is fed, said workpiece being held on said holding surface of said first molding die;
a decompression chamber that is formed between said first molding die and said second molding die and configured to be openable and closeable;
a driving part that forms said decompression chamber by bringing one or both of said first molding die and said second molding die close to the other or to each other relatively in an opposing direction of said first molding die and said second molding die;
a pressure regulating part that exhaust air from said decompression chamber and an outer space or supply air thereto to regulate an internal pressure from an air atmosphere to a decompression atmosphere of a predetermined degree of vacuum; and
a controlling part that controls operations of said driving part and said pressure regulating part,
wherein said holding surface of said first molding die has an adhesive part that detachably comes into contact with a non-mounting surface provided on a side opposite to said mounting surface of said workpiece, and
said controlling part controls to cause said driving part to immerse said mounting surface of said workpiece in said uncured resin in said cavity in a state where said decompression chamber is brought to a high vacuum of approximately 100 Pa or lower by said pressure regulating part.

2. The resin-sealing device according to claim 1, wherein a plurality of said adhesive parts are arranged dispersedly on said holding surface of said first molding die.

3. The resin-sealing device according to claim 1 or 2, wherein said adhesive part has an adhesive surface that is elastically deformable and protrudes from said holding surface of said first molding die toward said decompression chamber.

4. The resin-sealing device according to claim 3, wherein said holding surface of said first molding die has a pushing part that moves said workpiece toward said adhesive surface of said adhesive part and presses said workpiece against said adhesive surface.

5. A resin-sealing method, comprising:
a carrying-in step for, under an air atmosphere, causing an adhesive part, which is provided on a holding surface of said first molding die, to adhesively hold a workpiece on which a semiconductor element is mounted, against said holding surface of said first molding die that is moved away relatively in an opposing direction of said first molding die and said second molding die, and supplying an uncured resin to a cavity of said second molding die;
a decompression step for causing said driving part to bring one or both of said first molding die and said second molding die close to the other or to each other relatively in the opposing direction of said first molding die and said second molding die, thereby forming a decompression chamber between said first molding die and said second molding die, and causing a pressure regulating part to exhaust air from said decompression chamber to an outer space, to decompress said decompression chamber from the air atmosphere;
an immersing step for causing said driving part to immerse said mounting surface of said workpiece and said semiconductor element in said uncured resin in said cavity in a state where said decompression chamber reaches a high vacuum of approximately 100 Pa or lower;
a curing step for curing said uncured resin to resin-seal said mounting surface of said workpiece and said semiconductor element; and
a carrying-out step for causing said pressure regulating part to bring said decompression chamber back to the air atmosphere by supplying air thereto from said outer space, peeling a non-mounting surface, provided on a side opposite to said mounting surface of said workpiece, from said adhesive part on said mounting surface of said workpiece, and causing said driving part to move said first molding die and said second molding die away from each other.
